# EUROPÄISCHE PATENTSCHRIFT

(11) **EP 2 052 300 B1**
(45) Veröffentlichungstag und Bekanntmachung des Hinweises auf die Patenterteilung: **17.11.2010**
(21) Anmeldenummer: 07786541.8
(22) Anmeldetag: 03.08.2007
(51) Int. Cl.: G05B 19/042, G11C 16/10

(54) **VERFAHREN ZUR PROGRAMMIERUNG EINES STEUERGERÄTES EINES KRAFTFAHRZEUGS**
METHOD FOR PROGRAMMING A CONTROLLER IN A MOTOR VEHICLE
PROCEDE DE PROGRAMMATION D'UN MODULE DE COMMANDE D'UN VEHICULE AUTOMOBILE

(30) Priorität: 17.08.2006 DE 102006038428
(43) Veröffentlichungstag der Anmeldung: 29.04.2009
(73) Patentinhaber: Bayerische Motoren Werke Aktiengesellschaft, 80809 München (DE)
(72) Erfinder: TORLO, Marc, 85551 Kirchheim (DE); MÜLLER, Stefan, 85540 Haar-Gronsdorf (DE)
(74) Vertreter: Grüter, Klaus Peter
(86) Internationale Anmeldenummer: PCT/EP2007/006872
(87) Internationale Veröffentlichungsnummer: WO 2008/019767

(56) Entgegenhaltungen:
- US-B1- 6 405 279

## Beschreibung

Die Erfindung betrifft insbesondere ein Verfahren zur Programmierung eines Steuergerätes eines Kraftfahrzeugs gemäß dem Oberbegriff des Anspruchs 1.

In heutigen Steuergeräten in Kraftfahrzeugen werden zur Fehlerbehebung und nachträglichen Adaption von Software sog. Flash-Bausteine bzw. Flash-EEPROMs verwendet. Bei diesen Flash-Bausteinen dauert das Einschreiben einer Informationsmenge deutlich länger als das Auslesen derselben Informationsmenge. Da die von den Steuergeräten mittels programmgesteuerter Prozessoren auszuführenden Funktionen immer komplexer werden, erfordern die Programmsteuerungen bzw. die Software der Steuergeräte und die zur Ausführung im Steuergerät zu hinterlegenden Daten, wie Kennfelder, mehr und mehr Speicherplatz. Dieser zunehmende Speicherplatz kann bereitgestellt werden, indem anstelle von einem Speicher-Baustein zwei oder mehr Speicher-Bausteine im Steuergerät implementiert werden. Die zwei oder mehr Speicherbausteine werden der Reihe nach mit Programmen, Programmteilen und/oder Daten beschrieben.

Ist bei einem oder mehreren im Fahrzeug verbauten Steuergeräten ein Software-Update erforderlich, z.B. in der Werkstatt, dauert das Einschreiben der Software in die Speicher-Bausteine recht lange, was den Werkstattaufenthalt teuer macht.

Aus der US-B1-6 405 279 ist eine Vorrichtung zur Steuerung eines vorbestimmten Steuerungsobjekts auf der Grundlage von in einem erneut beschreibbaren nichtflüchtigen Speicher gespeicherten Daten bekannt. Sie weist einen ersten Speicherbereich auf, um in den nichtflüchtigen Speicher zu schreibende Daten von außerhalb zu empfangen und darin zu speichern. Es ist zudem ein zweiter Speicherbereich vorgesehen, der getrennt von dem ersten Speicherbereich angeordnet ist, zum Speichern der in dem ersten Speicherbereich gespeicherten Daten als in den nichtflüchtigen Speicher zu schreibende Daten. Eine Verarbeitung zum Empfang der Daten für den ersten Speicherbereich und eine Verarbeitung zum Schreiben der in dem zweiten Speicherbereich gespeicherten Schreibdaten in den nichtflüchtigen Speicher wird parallel ausgeführt.

Aufgabe der vorliegenden Erfindung ist es insbesondere ein Verfahren zur Programmierung eines Steuergerätes eines Kraftfahrzeugs bereitzustellen, bei dem das Einschreiben von Speicherinhalten schneller erfolgt.

Diese Aufgabe wird durch die im Anspruch 1 angegebenen Maßnahmen gelöst. Vorteilhafte Ausgestaltungen der Erfindung sind Gegenstand der abhängigen Ansprüche.

Ein wesentlicher Aspekt der Erfindung besteht darin, dass der Prozessor zumindest zeitweise weitgehend gleichzeitig die folgenden zwei Schritte ausführt oder veranlasst. Diese sind zum einen, Prüfen, ob bereits in den ersten Speicherbereich geschriebene Programme, Programmteile und/oder Daten den in den ersten Speicherbereich zu schreibenden Daten entsprechen, und zum anderen, Schreiben eines Programms, eines Programmteils und/oder von Daten in den zweiten Speicherbereich.

Bei den zwei Speicherbereichen handelt es sich insbesondere um zwei physikalisch getrennte Speicherbausteine.

Während des Schreibens in einen Speicherbereich ist der Prozessor des Steuergeräts in der Regel nicht vollständig mit diesem Prozess ausgelastet. Die noch zur Verfügung stehenden, bislang ungenutzten Ressourcen des programmgesteuerten Prozessors können erfindungsgemäß genutzt werden, um zusätzlich zum ersten Speicherbereich auch in den zweiten Speicherbereich bzw. ggf. in den ersten und den zweiten Speicher-Baustein zu schreiben. Erfindungsgemäß ist vorgesehen, dass nach dem Abschluss des Schreibvorgangs am zweiten Speicherbereich, während der Schreibvorgang am ersten Speicherbereich noch nicht abgeschlossen ist, unter Verwendung der ungenutzten Ressourcen des programmgesteuerten Prozessors überprüft wird, ob die in den zweiten Speicherbereich tatsächlich eingeschriebenen Programme, Programmteile und/oder Daten identisch zu den zum Einschreiben vorgesehenen Programmen, Programmteilen und/oder Daten sind.

Bekannt ist diese Überprüfung erst nach dem Abschluss der Schreibvorgänge in die zwei oder mehr Speicherbereiche vorzunehmen, d.h. beachtliche Ressourcen des programmgesteuerten Prozessors des betreffenden Steuergeräts liegen lange Zeit "brach" und beim späteren Überprüfen, ob die Daten korrekt in die Speicherbereiche eingeschrieben worden sind, steigt die Auslastung des Prozessors so stark an, dass sich die Überprüfung und damit der gesamte Schreibvorgang unerwünscht lange hinzieht. Durch die erfindungsgemäße Verschiebung von den Prozessor stark belastenden Aufgaben in eine zeitliche Phase geringer Auslastung des Prozessors, lässt sich der Programmiervorgang von Steuergeräten mit zwei und mehr einzeln adressierbaren Speicherbereichen bzw. Speicher-Bausteinen deutlich beschleunigen. Zudem wird der Programmiervorgang hierdurch insgesamt stabiler und damit zuverlässiger.

Bei einer Ausführungsform der Erfindung wird anhand des bekannten CRC-Verfahrens (Cyclic Redundancy Check) überprüft, ob bereits in den ersten Speicherbereich geschriebene Daten den in den ersten Speicherbereich zu schreibenden Daten entsprechen. Eine Abweichung in Folge einer technischen Störung bei der Übertragung oder beim Einschreiben der Daten kann durch das CRC-Verfahren erkannt werden.

Bei einer anderen Ausführungsform wird, bevorzugt ergänzend zum CRC-Verfahren, überprüft, ob die Daten während der Übertragung und/oder beim Einschreiben in den Speicherbereich verfälscht bzw. geändert worden sind. Dies erfolgt erfindungsgemäß anhand des an sich bekannten Vergleichs des Hash-Werts der zu schreibenden Daten mit dem Hash-Wert der tatsächlich geschriebenen Daten. Bei einer Weiterbildung der Erfindung wird die Übereinstimmung auf der Basis eines an sich bekannten Signatur-Verfahrens vorgenommen, bei der ein mit einem geheimen Schlüssel verschlüsselter Soll-Hash-Wert mit dem zum geheimen Schlüssel komplementären öffentlichen Schlüssel entschlüsselt wird (Public-Key-Verfahren) und der entschlüsselte Soll-Hash-Wert mit dem Ist-Hash-Wert der eingeschriebenen Daten verglichen wird.

Das Public-Key-Verfahren oder ein anderes Verschlüsselungsverfahren stellt besonders hohe Anforderungen an den programmgesteuerten Prozessor des Steuergeräts und sorgt beim bekannten Programmierverfahren für besonders lange Programmierzeiten. Diese können durch die Verwendung der erfindungsgemäßen Lehre signifikant verkürzt werden.

Bei einer Ausführungsform der Erfindung wird auf der Basis des Signatur-Verfahrens geprüft, ob die in den jeweiligen Speicherbereich geschriebenen Daten den in den jeweiligen Speicherbereich zu schreibenden Daten entsprechen. Bei dieser Ausführungsform gelten die Daten als nicht manipuliert, wenn die Daten in jedem der Speicherbereiche für sich genommen den zu schreibenden Daten entsprechen.

Bei einer anderen Ausführungsform der Erfindung wird auf der Basis des Signatur-Verfahrens geprüft, ob die in den jeweiligen Speicherbereich geschriebenen Daten den in den jeweiligen Speicherbereich zu schreibenden Daten entsprechen und es wird anhand eines weiteren Signatur-Prüfungsschritts geprüft, ob die Gesamtheit der Daten in den zwei oder mehr Speicherbereichen von der Gesamtheit der zu schreibenden Daten abweicht.

Bei einer Ausführungsform der Erfindung wird im Rahmen des Signatur-Verfahrens geprüft, ob der Hash-Wert und/oder die Signatur für die tatsächlich in den ersten Speicherbereich geschriebenen Programme, Programmteile und/oder Daten mit dem Hash-Wert und/oder mit der Signatur für die in den ersten Speicherbereich zu schreibenden Programme, Programmteile und/oder Daten übereinstimmt.

Bei einer anderen Ausführungsform der Erfindung wird der Hash-Wert und/oder die Signatur für die in den ersten Speicherbereich tatsächlich eingeschriebenen Programme, Programmteile und/oder Daten ermittelt, weiter wird der Hash-Wert und/oder die Signatur für die in den zweiten Speicherbereich tatsächlich eingeschriebenen Programme, Programmteile und/oder Daten ermittelt. Die beiden Hash-Werte und/oder Signaturen werden zusammengefasst und der zusammengefasste Hash-Wert und/oder die zusammengefasste Signatur wird mit einem einzigen Hash-Wert und/oder einer einzigen Signatur verglichen.

Bevorzugt handelt es sich bei den erfindungsgemäßen Speicherbereichen um zwei oder mehr einzeln adressierbare nichtflüchtige Flash-EEPROMs.

## Patentansprüche

1. Verfahren zur Programmierung eines Steuergerätes eines Kraftfahrzeugs, wobei das Steuergerät einen programmgesteuerten Prozessor und mindestens zwei einzeln adressierbare Speicherbereiche aufweist, **dadurch gekennzeichnet, dass** der Prozessor zumindest zeitweise gleichzeitig die folgenden Schritte ausführt oder veranlasst:
- Prüfen, ob bereits in den ersten Speicherbereich geschriebene Programme, Programmteile und/oder Daten den in den ersten Speicherbereich zu schreibenden Daten entsprechen, und
- Schreiben eines Programms, eines Programmteils und/oder von Daten in den zweiten Speicherbereich.

2. Verfahren nach Anspruch 1, **dadurch gekennzeichnet, dass** das Prüfen, ob bereits in den ersten Speicherbereich geschriebene Daten den in den ersten Speicherbereich zu schreibenden Daten entsprechen, anhand des CRC-Verfahrens erfolgt.

3. Verfahren nach Anspruch 1 oder 2, **dadurch gekennzeichnet, dass** das Prüfen, ob bereits in den ersten Speicherbereich geschriebene Daten den in den ersten Speicherbereich zu schreibenden Daten entsprechen, anhand eines Vergleichs des Hash-Werts der zu schreibenden Daten mit dem Hash-Wert der tatsächlich geschriebenen Daten erfolgt.

4. Verfahren nach einem der vorstehenden Ansprüche, **dadurch gekennzeichnet, dass** das Prüfen, ob bereits in den ersten Speicherbereich geschriebene Daten den in den ersten Speicherbereich zu schreibenden Daten entsprechen, anhand eines Signatur-Verfahrens erfolgt.

5. Verfahren nach Anspruch 4, **dadurch gekennzeichnet, dass** auf der Basis des Signatur-Verfahrens geprüft wird, ob die in den zweiten Speicherbereich geschriebenen Daten den in den zweiten Speicherbereich zu schreibenden Daten entsprechen.

6. Verfahren nach einem der Ansprüche 4 oder 5, **dadurch gekennzeichnet, dass** im Rahmen des Signatur-Verfahrens geprüft wird, ob der Hash-Wert und/oder die Signatur für die tatsächlich in den ersten Speicherbereich geschriebenen Programme, Programmteile und/oder Daten mit dem Hash-Wert und/oder mit der Signatur für die in den ersten Speicherbereich zu schreibenden Programme, Programmteile und/oder Daten übereinstimmt.

7. Verfahren nach einem der Ansprüche 4 bis 6, **dadurch gekennzeichnet, dass** im Rahmen des Signatur-Verfahrens geprüft wird, ob der Hash-Wert und/oder die Signatur für die tatsächlich in den zweiten Speicherbereich geschriebenen Programme, Programmteile und/oder Daten mit dem Hash-Wert und/oder mit der Signatur für die in den zweiten Speicherbereich zu schreibenden Programme, Programmteile und/oder Daten übereinstimmt.

8. Verfahren nach Anspruch 6 und 7, **dadurch gekennzeichnet, dass** die Übereinstimmung für beide Speicherbereiche als gegeben gilt, wenn der Hash-Wert und/oder die Signatur für die beiden Speicherbereiche jeweils für sich als übereinstimmend ermittelt worden ist.

9. Verfahren nach einem der vorstehenden Ansprüche, **dadurch gekennzeichnet, dass** der Hash-Wert und/oder die Signatur für die in den ersten Speicherbereich tatsächlich eingeschriebenen Programme, Programmteile und/oder Daten ermittelt wird, dass der Hash-Wert und/oder die Signatur für die in den zweiten Speicherbereich tatsächlich eingeschriebenen Programme, Programmteile und/oder Daten ermittelt wird, dass die beiden Hash-Werte und/oder Signaturen zusammengefasst und der zusammengefasste Hash-Wert und/oder die zusammengefasste Signatur mit einem einzigen Hash-Wert und/oder einer einzigen Signatur verglichen wird.

10. Verfahren nach einem der vorstehenden Ansprüche, **dadurch gekennzeichnet, dass** der erste Speicherbereich und der zweite Speicherbereich durch jeweils einen nichtflüchtigen elektronischen Speicher bereitgestellt werden.

11. Verfahren nach Anspruch 10, **dadurch gekennzeichnet, dass** der nichtflüchtige Speicher ein EEPROM ist.

12. Vorrichtung zur Programmierung eines Steuergerätes eines Kraftfahrzeugs, **dadurch gekennzeichnet, dass** die Vorrichtung ein Verfahren nach einem der vorstehenden Ansprüche ausführt.

13. Computerprogramm mit Programmcode zur Durchführung aller Verfahrensschritte nach einem der vorstehenden Ansprüche, wenn das Programm in einem Computer ausgeführt wird.

## Claims

1. A method for programming a controller of a motor vehicle, the controller having a programme-controlled processor and at least two individually addressable memory areas, **characterised in that** the processor simultaneously carries out or initiates, at least intermittently, the following steps:
- checking whether programmes, programme parts and/or data already written in the first memory area correspond to the data to be written into the first memory area, and
- writing a programme, a programme part and/or data into the second memory area.

2. A method according to claim 1, **characterised in that** the checking whether data already written into the first memory area correspond to the data to be written into the first memory area, takes place with the aid of the CRC method.

3. A method according to claim 1 or 2, **characterised in that** the checking whether data already written into the first memory area correspond to the data to be written into the first memory area, takes place using a comparison of the hash value of the data to be written with the hash value of the data actually written.

4. A method according to any one of the preceding claims, **characterised in that** the checking whether the data already written into the first memory area correspond to the data to be written into the first memory region, takes place using a signature method.

5. A method according to claim 4, **characterised in that** a check is made on the basis of the signature method, whether the data written into the second memory area correspond to the data to be written into the second memory area.

6. A method according to either of claims 4 or 5, **characterised in that** in the framework of the signature method a check is made whether the hash value and/or the signature for the programmes, programme parts and/or data actually written into the first memory area coincides with the hash value and/or with the signature for the programmes, programme parts and/or data to be written into the first memory area.

7. A method according to any one of claims 4 to 6, **characterised in that** a check is made in the framework of the signature method whether the hash value and/or the signature for the programmes, programme parts and/or data actually written into the second memory area coincides with the hash value and/or with the signature for the programmes, programme parts and/or data to be written into the second memory area.

8. A method according to claim 6 and 7, **characterised in that** the coincidence of the two memory areas is considered to be provided when the hash value and/or the signature for the two memory areas has been determined, separately in each case, to be coinciding.

9. A method according to any one of the preceding claims, **characterised in that** the hash value and/or the signature for the programmes, programme parts and/or data actually written into the first memory area is determined, **in that** the hash value and/or the signature for the programmes, programme parts and/or data actually written into the second memory area is determined, **in that** the two hash values and/or signatures are combined and the combined hash value and/or the combined signature is compared with a single hash value and/or a single signature.

10. A method according to any one of the preceding claims, **characterised in that** the first memory area and the second memory area are provided by a respective non-volatile electronic memory.

11. A method according to claim 10, **characterised in that** the non-volatile memory is an EEPROM.

12. A device for programming a controller of a motor vehicle, **characterised in that** the device carries out a method according to any one of the preceding claims.

13. A computer programme with a programme code for carrying out all the method steps according to any one of the preceding claims, when the programme is run in a computer.

## Revendications

1. Procédé de programmation d'un appareil de commande d'un véhicule automobile, selon lequel :
l'appareil de commande comporte un processeur commandé par programme et au moins deux zones de mémoire adressables séparément, procédé **caractérisé en ce que**
le processeur exécute ou commande simultanément au moins de temps en temps, les étapes suivantes :
- contrôler si les programmes, parties de programme et/ou données déjà inscrites dans la première zone de mémoire, correspondent aux données à inscrire dans la première zone de mémoire, et
- inscrire un programme, une partie de programme et/ou des données dans la seconde zone de mémoire.

2. Procédé selon la revendication 1,
**caractérisé en ce qu'**
on contrôle pour savoir si les données déjà inscrites dans la première zone de mémoire correspondent aux données à inscrire dans la première zone de mémoire se fait par le procédé CRC.

3. Procédé selon la revendication 1 ou 2,
**caractérisé en ce que**
contrôler si les données déjà inscrites dans la première zone de mémoire correspondent aux données à inscrire dans la première zone de mémoire, se fait par la comparaison de la valeur Hash des données à inscrire et de la valeur Hash des données effectivement inscrites.

4. Procédé selon l'une des revendications précédentes,
**caractérisé en ce que**
contrôler si les données déjà inscrites dans la première zone de mémoire correspondent aux données à inscrire dans la première zone de mémoire, se fait par un procédé de signature.

5. Procédé selon la revendication 4,
**caractérisé en ce qu'**
on vérifie par le procédé de signature, si les données inscrites dans la seconde zone de mémoire, correspondent aux données à inscrire dans la seconde zone de mémoire.

6. Procédé selon l'une des revendications 4 ou 5,
**caractérisé en ce que**
dans le cadre du procédé de signature, on vérifie si la valeur Hash et/ou la signature des programmes, parties de programme et/ou données effectivement inscrites dans la première zone de mémoire, correspondent à la valeur Hash et/ou à la signature des programmes, parties de programme et/ou données à inscrire dans la première zone de mémoire.

7. Procédé selon l'une des revendications 4 à 6,
**caractérisé en ce que**
dans le cadre du procédé de signature, on vérifie si la valeur Hash et/ou la signature des programmes, parties de programme et/ou données effectivement inscrites dans la seconde zone de mémoire, correspondent à la valeur Hash et/ou à la signature des programmes, parties de programme et/ou données à inscrire dans la seconde zone de mémoire.

8. Procédé selon les revendications 6 et 7,
**caractérisé en ce que**
la concordance des deux zones de mémoire est considérée comme valable si la valeur Hash et/ou la signature des deux zones de mémoire ont été respectivement déterminées comme se concordant.

9. Procédé selon l'une des revendications précédentes,
**caractérisé en ce qu'**
on détermine la valeur Hash et/ou la signature des programmes, parties de programme et/ou données effectivement inscrites dans la première zone de mémoire,
on détermine la valeur Hash et/ou la signature des programmes, parties de programme et/ou données effectivement inscrites dans la seconde zone de mémoire,
on réunit les deux valeurs Hash et/ou signatures et on compare la valeur Hash groupée et/ou la signature groupée à une unique valeur Hash et/ou une unique signature.

10. Procédé selon l'une des revendications précédentes,
**caractérisé en ce que**
la première zone de mémoire et la seconde zone de mémoire sont constituées chacune par une mémoire électronique non volatile.

11. Procédé selon la revendication 10,
**caractérisé en ce que**
la mémoire non volatile est une mémoire EEPROM.

12. Dispositif de programmation d'un appareil de commande d'un véhicule automobile,
**caractérisé en ce que**
le dispositif exécute un procédé selon l'une des revendications précédentes.

13. Programme d'ordinateur avec un code programme pour la mise en oeuvre de toutes les étapes de procédé selon l'une des revendications précédentes, lorsque le programme est exécuté par un ordinateur.
